(19) Europäisches Patentamt / European Patent Office / Office européen des brevets

(11) **EP 3 857 692 B1**

(12) **FASCICULE DE BREVET EUROPEEN**

(45) Date de publication et mention
de la délivrance du brevet:
**02.11.2022 Bulletin 2022/44**

(21) Numéro de dépôt: **19836467.1**

(22) Date de dépôt: **19.09.2019**

(51) Classification Internationale des Brevets (IPC):
**H02M 3/158** (2006.01)  **H02M 1/00** (2006.01)

(52) Classification Coopérative des Brevets (CPC):
**H02M 3/1584;** H02M 1/0003; H02M 3/1586

(86) Numéro de dépôt international:
**PCT/EP2019/075225**

(87) Numéro de publication internationale:
**WO 2020/069878 (09.04.2020 Gazette 2020/15)**

(54) **PROCÉDÉ DE COMMANDE D'UN CONVERTISSEUR DE TYPE BOOST À N CELLULES DE COMMUTATIONS**

STEUERVERFAHREN EINES BOOST-WANDLERS MIT N WANDLERZELLEN

CONTROL METHOD OF A BOOST CONVERTER HAVING N COMMUTATION CELLS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **24.09.2018 FR 1858626**

(43) Date de publication de la demande:
**04.08.2021 Bulletin 2021/31**

(73) Titulaires:
• **Renault s.a.s**
**92100 Boulogne Billancourt (FR)**
• **Nissan Motor Co., Ltd.**
**Yokohama-shi, Kanagawa 221-0023 (JP)**

(72) Inventeurs:
• **ROUHANA, Najib**
**91300 Massy (FR)**
• **MALOUM, Abdelmalek**
**94550 Chevilly Larue (FR)**

(74) Mandataire: **Renault Group
Renault s.a.s.
API : TCR GRA 2 36
1, Avenue du Golf
78084 Guyancourt Cedex (FR)**

(56) Documents cités:
**CN-B- 105 656 022**

• **GAVAGSAZ-GHOACHANI ROGHAYEH ET AL:
"Control of a Two-Phase Interleaved Boost
Converter with Input LC Filter for Fuel Cell Vehicle
Applications", 2017 IEEE VEHICLE POWER AND
PROPULSION CONFERENCE (VPPC), IEEE, 11
décembre 2017 (2017-12-11), pages 1-5,
XP033344236, DOI: 10.1109/VPPC.2017.8330973**
• **HUANGFU YIGENG ET AL: "Flatness-based and
Super-Twisting Controllers of Output Series
Interleaved Boost Converter for Fuel Cell
Applications", 2018 IEEE INDUSTRY
APPLICATIONS SOCIETY ANNUAL MEETING
(IAS), IEEE, 23 septembre 2018 (2018-09-23),
pages 1-7, XP033453819, DOI:
10.1109/IAS.2018.8544625**
• **RENAUDINEAU H ET AL: "Flatness-based
control of a boost inverter for PV microinverter
application", 2017 IEEE 8TH INTERNATIONAL
SYMPOSIUM ON POWER ELECTRONICS FOR
DISTRIBUTED GENERATION SYSTEMS (PEDG),
IEEE, 17 avril 2017 (2017-04-17), pages 1-6,
XP033116119, DOI: 10.1109/PEDG.2017.7972446**

**Description**

La présente invention se rapporte à un procédé de commande d'un convertisseur de type *Boost* à N cellules de commutations.

L'invention concerne un convertisseur DC/DC Boost, connu en anglais sous le nom de *Step-Up,* qui est un convertisseur élévateur de tension continue.

Le document suivant divulgue un procédé de commande d'un convertisseur boost à N cellules de commutations: R. Gavagsaz-Ghoachani, M. Zandi, J. Martin, S. Pierfederici, M. Phattanasak and B. Nahid-Mobarakeh, "Control of a Two-Phase Interleaved Boost Converter with Input LC Filter for Fuel Cell Vehicle Applications," 2017 IEEE Vehicle Power and Propulsion Conférence (VPPC), 2017, pp. 1-5.

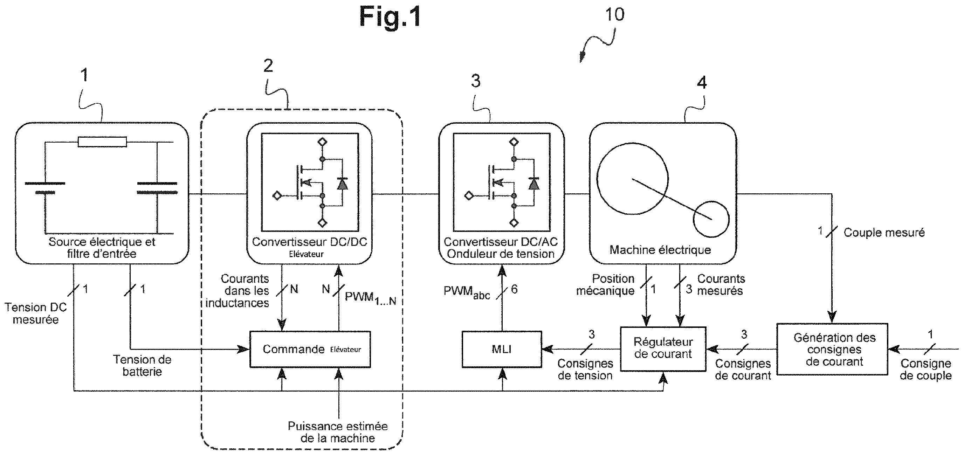

Dans le domaine des véhicule automobiles, hybrides ou électriques, il est connu d'employer des convertisseurs Boost 2 dans un ensemble électrique 10 comprenant une machine électrique 4 de traction, telle que représentée en figure 1.

Dans un tel ensemble électrique 10 le convertisseur *Boost* 2 est placé en amont de l'onduleur de tension 3 et de la machine électrique 4, considérés comme étant une source de courant dynamique.

Le convertisseur *Boost* 2 est toutefois positionné en aval de la source électrique 1 et des filtres d'entrées.

Un convertisseur Boost 2 est un convertisseur de type DC-DC. Il a donc pour objectif de fournir à la charge qu'il alimente, une tension continue supérieure ou égale à celle mesurée en entrée.

Ce type de convertisseur est un système à phase non minimale. En effet, la fonction de transfert qui relie la tension de sortie à la commande, notée $H(s)$, présente dans le plan complexe, un zéro ayant une partie réelle positive.

D'après un développement en modèle petits signaux et linéarisation autour d'un point de fonctionnement stabilisé donné, la fonction de transfert $H(s)$ a la forme suivante :

$$H(s) = \frac{\tilde{v}_{out}}{\tilde{d}} = \frac{(s - z_1)}{(s - p_1)(s - p_2)}$$

Avec $z_1 > 0$, $p_1 < 0$ et $p_2 < 0$ sont le zéro et les pôles de la fonction de transfert $H(s)$ respectivement.

D'autre part, un convertisseur boost est un système à phase non minimale qui présente une réponse en sortie qui est initialement inverse à la variation de l'entrée. La sortie a tendance de diverger avant de converger vers le point stabilisé. On parle d'une phase de décrochage de la tension de sortie. De plus, les relations entre, d'une part, ses différents états et, d'autre part, la commande est non-linéaire.

Aussi un problème général est de commander de manière stable et rapide, les convertisseurs *Boost* à N cellules de commutation, avec N un entier naturel non nul.

On connaît notamment de l'art antérieur le document US2017/0257038A1 qui décrit un procédé de commande d'un convertisseur *Boost* à N phases, avec N un entier naturel non nul. Ce procédé vise à modifier la fréquence de découpage du système et rajoute un déphasage entre les commandes des différentes cellules afin d'éviter la fréquence de résonance du bus continu. Toutefois une telle solution ne permet pas d'obtenir une commande à la fois stable, dynamique et rapide.

Aussi, une problématique bien connue est d'obtenir une commande plus stable et plus rapide d'un tel convertisseur Boost au lieu d'utiliser une commande avec des boucles en cascade ce qui a tendance à limiter la dynamique de la commande vis-à-vis des perturbations externes.

On propose un procédé de commande d'un convertisseur *Boost* à N cellules de commutations en modulation de largeur d'impulsion synchrone, dans lequel N est un entier naturel non nul, le convertisseur recevant en entrée une tension électrique $V_{in}$ continue d'une source de tension et fournissant en sortie une tension de sortie $V_{out}$ supérieure ou égale à la tension d'entrée $V_{in}$, le procédé comprenant :

- Une étape de mesure des tensions d'entrée $V_{in}$ et de sortie $V_{out}$ dudit convertisseur *Boost* ;
- Une étape de détermination d'un vecteur de sortie y adapté pour linéariser globalement le système d'équations du convertisseur *Boost*;
- Une étape de calcul de la variation de puissance de la charge électrique $\dot{P}_{out}$ en sortie du convertisseur;
- Une étape de détermination des N rapports cycliques du convertisseur en fonction de la dérivée seconde ÿ du vecteur de sortie y, de la dérivée de la puissance de la charge électrique $\dot{P}_{out}$ et du rapport entre la tension d'entrée $V_{in}$ et la tension de sortie $V_{out}$ mesurées ; et
- Une étape de commande de chaque cellule de commutation du convertisseur, en fonction du rapport cyclique déterminé.

Ainsi on peut obtenir un procédé de commande par commande non-linéaire d'un convertisseur à *N* cellules de commutation à travers une linéarisation globale et une compensation de non linéarités à travers une commande qui garantit une convergence asymptotique stable de l'erreur. Cette approchepermet de réguler la tension de sortie du convertisseur DC-DC, tension mesurée aux bornes du condensateur de découplage en entrée de l'onduleur de tension, à la tension de consigne imposée par l'utilisateur, tout en garantissant une stabilité globale du système et en assurant une relativement bonne réactivité et dynamique de la commande vis-à-vis des perturbations externes.

Avantageusement et de manière non limitative, lorsque le convertisseur comprend N>1 cellules de commutations, l'étape de détermination des N rapports cycliques comprend le calcul du flux d'énergie $\dot{\Psi}_k$ traversant chaque cellule de commutation. Ainsi on peut obtenir un calcul tenant compte de la dynamique du convertisseur.

Avantageusement et de manière non limitative, l'étape de détermination des N rapports cycliques comprend ;

- Le calcul du rapport cyclique ($\alpha_1$) pour la première cellule de commutation (k=1) en fonction de la somme des flux d'énergie calculés ($\dot{\Psi}_k$) pour les cellules de commutation à partir de la deuxième par application de la formule suivante :

$$(1 - \alpha_1) = \frac{V_{in}}{V_{out}} - \frac{L_1}{NV_{out}}\left[\frac{\ddot{y}}{V_{in}} + \sum_{k=2}^{N} \dot{\Psi}_k + \frac{\dot{P}_{out}}{V_{in}}\right]$$

Avantageusement et de manière non limitative, l'étape de détermination des N rapports cycliques comprend le calcul du rapport cyclique de chaque cellule de commutation autre que la première, en fonction des flux d'énergie calculés par application du système d'équations suivant :

$$\begin{cases} (1 - \alpha_2) = \frac{V_{in}}{V_{out}} - \frac{L_2}{NV_{out}}\left[\frac{\ddot{y}}{V_{in}} - (N-1)\dot{\Psi}_2 + \sum_{k=1}^{N-2}\sum_{\substack{m=N-(k-1)\\m\neq2}}^{N} \dot{\Psi}_m + \frac{\dot{P}_{out}}{V_{in}}\right] \\ (1 - \alpha_3) = \frac{V_{in}}{V_{out}} - \frac{L_3}{NV_{out}}\left[\frac{\ddot{y}}{V_{in}} - (N-1)\dot{\Psi}_3 + \sum_{k=1}^{N-2}\sum_{\substack{m=N-(k-1)\\m\neq3}}^{N} \dot{\Psi}_m + \frac{\dot{P}_{out}}{V_{in}}\right] \\ \qquad\qquad\qquad\qquad\qquad\vdots \\ (1 - \alpha_N) = \frac{V_{in}}{V_{out}} - \frac{L_3}{NV_{out}}\left[\frac{\ddot{y}}{V_{in}} - (N-1)\dot{\Psi}_{N-1} + \sum_{k=1}^{N-2}\sum_{\substack{m=N-(k-1)\\m\neq N}}^{N} \dot{\Psi}_m + \frac{\dot{P}_{out}}{V_{in}}\right] \end{cases}$$

Avantageusement et de manière non limitative, lorsque le convertisseur comprend une unique cellule de commutation, l'étape de détermination du rapport cyclique comprend l'application de l'équation suivante :

$$\alpha_1 = 1 - \frac{V_{in}}{V_{out}} + \frac{L_1}{V_{in}V_{out}}\left[\ddot{y} + \dot{P}_{out}\right]$$

Ainsi, on peut obtenir une étape de calcul du rapport cyclique plus simple lorsque le convertisseur ne comprend qu'une cellule de commutation.

Avantageusement et de manière non limitative, l'étape de commande de chaque cellule de commutation comprend la génération d'un signal de commande pour chaque cellule de commutation, fonction d'une comparaison logique entre les rapports cycliques déterminés et un signal porteuse triangulaire symétrique haute-fréquence, imposant une fréquence de découpage au convertisseur. Avantageusement et de manière non limitative, la comparaison comprend : pour la première cellule de commutation (k=1) :

- Si $\alpha_1 \geq$ *porteuse*$_1$, *PWM*$_1$ = 1;
- Si non, *PWM*$_1$ = 0;

Pour les autres cellules de commutation (k>1) :

- Si $\alpha_k \geq porteuse_k$, $PWM_k = 1$;
- Si non, $PWM_k = 0$;

Avec $porteuse_k$ déphasée de $porteuse_1$ de $2q\pi/N$ où $q$ est un entier naturel multiple de deux.

Ainsi, l'étape de commande est basée sur des comparaisons logiques simples assurant une exécution rapide de cette étape.

Avantageusement et de manière non limitative, le convertisseur *Boost* comprend pour chaque cellule de commutation une inductance et on calcule le vecteur de sortie en outre en fonction des courants mesurés pour chaque inductance. Ainsi, on peut calculer le vecteur de sortie de manière fiable.

Avantageusement et de manière non limitative, les valeurs moyennes des courants mesurés pour chaque inductance sont obtenues en échantillonnant à la valeur minimale ou maximale chacune des N porteuses utilisées pour la génération du découpage des interrupteurs de puissance.

L'invention concerne aussi un ensemble électrique comprenant une source électrique de courant continu, un convertisseur Boost à N cellules de commutation, un convertisseur de tension continu-alternatif, une machine électrique, et un dispositif de commande dudit convertisseur Boost adapté pour mettre en œuvre un procédé tel que décrit précédemment.

D'autres particularités et avantages de l'invention ressortiront à la lecture de la description faite ci-après d'un mode de réalisation particulier de l'invention, donné à titre indicatif mais non limitatif, en référence aux dessins annexés sur lesquels :

- la figure 1 est une vue de principe d'un ensemble d'alimentation électrique selon l'invention ;
- la figure 2 est une vue schématique d'un convertisseur *Boost* à N phases, N étant un entier naturel non nul, ici supérieur à 3, commandé selon le premier mode de réalisation de l'invention ;
- la figure 3 est une représentation schématique de l'étape de calcul de la variation de la puissance en sortie du convertisseur *Boost,* selon l'invention ;
- la figure 4 est une représentation graphique de l'étape d'échantillonnage des courants, pour le premier mode de réalisation de l'invention, dans un exemple à trois cellules de commutation entrelacées ;
- la figure 5 est une vue schématique du procédé de commande non-linéaire selon le premier mode de réalisation de l'invention ;
- la figure 6 est une vue schématique d'un convertisseur Boost mono-étage, commandé par le deuxième mode de réalisation de l'invention ; et
- la figure 7 est une vue schématique du procédé de commande non-linéaire selon le deuxième mode de réalisation de l'invention.

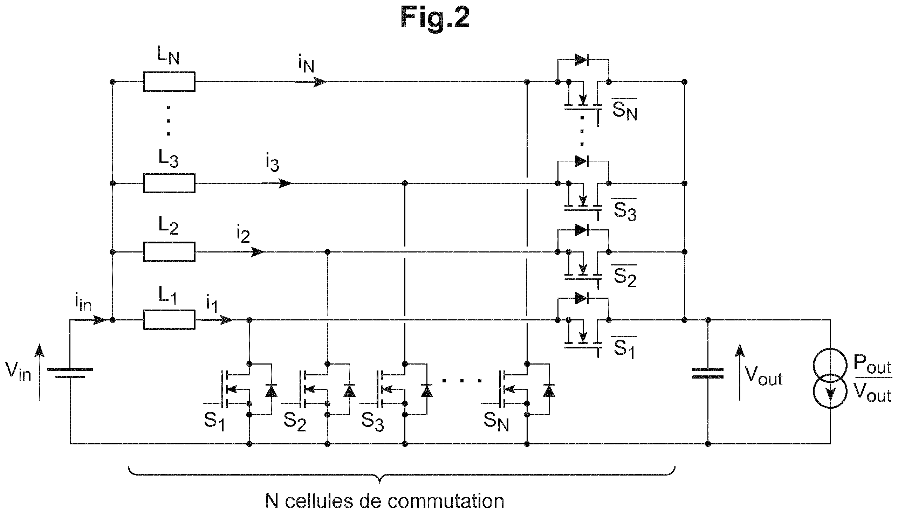

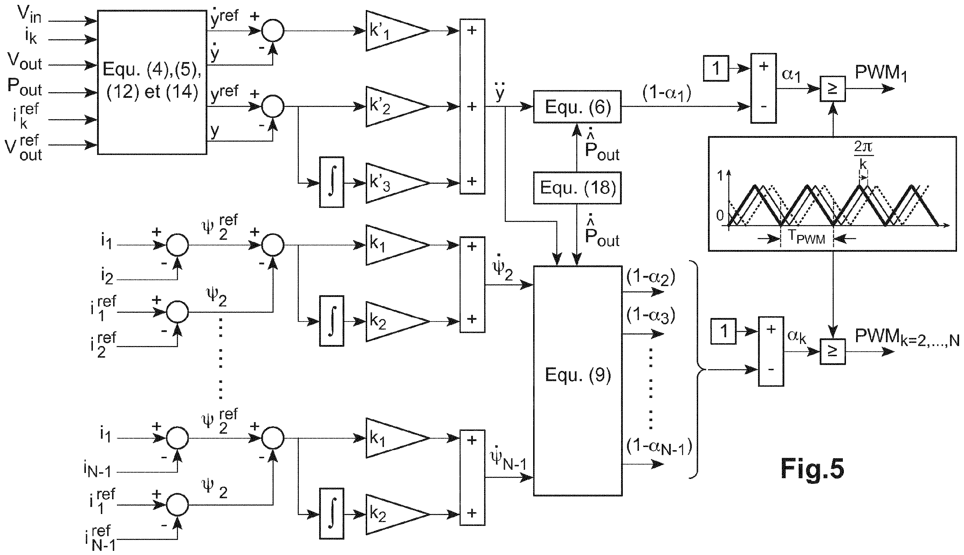

Dans un premier mode de réalisation de l'invention, en référence aux figures 1 à 5, on décrit un procédé de commande non-linéaire par linéarisation exacte avec retour d'état d'un convertisseur élévateur de tension à « N » cellules de commutations.

Ce procédé permet de compenser les non-linéarités que présente le système qu'on souhaite contrôler.

La forme de cette compensation est liée à la structure du système. A titre d'exemple, pour compenser un terme non-linéaire, noté $\mathcal{I}(x)$, par une soustraction, le vecteur de commande $u$ en entrée du système et le terme non-linéaire $\mathcal{I}(x)$ doivent apparaitre ensemble sous forme d'une addition $u + \mathcal{I}(x)$.

D'autre part, pour compenser $\mathcal{I}(x)$, par une division, le vecteur de commande $u$ et le terme non-linéaire doivent apparaître ensemble sous forme d'une multiplication $u \cdot \mathcal{I}(x)$.

Les équations du convertisseur *Boost* à $N$ cellules de commutation sont les suivantes :

$$\begin{cases} C_{out}\dfrac{dV_{out}}{dt} = (1-\alpha_1)i_1 + (1-\alpha_2)i_2 + \cdots + (1-\alpha_N)i_N - \dfrac{P_{out}}{V_{out}} \\[2mm] L_1\dfrac{di_1}{dt} = V_{in} - (1-\alpha_1)V_{out} \\[2mm] L_2\dfrac{di_2}{dt} = V_{in} - (1-\alpha_2)V_{out} \\[2mm] \vdots \\[2mm] L_N\dfrac{di_N}{dt} = V_{in} - (1-\alpha_N)V_{out} \end{cases} \qquad (1)$$

L'équation (1) peut s'écrire sous la forme générique d'une équation non-linéaire affine suivante :

$$\frac{dX}{dt} = f(X,t) + g(X,t) \cdot u(t) \tag{2}$$

Ainsi, l'équation (2) devient :

$$\begin{pmatrix} \frac{di_1}{dt} \\ \frac{di_2}{dt} \\ \vdots \\ \frac{di_N}{dt} \\ \frac{dV_{out}}{dt} \end{pmatrix} = \begin{pmatrix} \frac{V_{in} - V_{out}}{L_1} \\ \frac{V_{in} - V_{out}}{L_2} \\ \vdots \\ \frac{V_{in} - V_{out}}{L_N} \\ \frac{1}{C_{out}}\left(\sum_{k=1}^{N} i_k - \frac{P_{out}}{V_{out}}\right) \end{pmatrix} + \begin{pmatrix} \frac{V_{out}}{L_1} & 0 & \cdots & 0 \\ 0 & \frac{V_{out}}{L_2} & \cdots & 0 \\ 0 & 0 & \ddots & 0 \\ 0 & 0 & \cdots & \frac{V_{out}}{L_N} \\ -\frac{i_1}{C_{out}} & -\frac{i_2}{C_{out}} & \cdots & -\frac{i_N}{C_{out}} \end{pmatrix} \begin{pmatrix} \alpha_1 \\ \alpha_2 \\ \vdots \\ \alpha_N \end{pmatrix} \tag{3}$$

avec

- $X \in \mathbb{R}^n = (i_1 \quad i_2 \quad \dots \quad i_N \quad V_{out})^t$ le vecteur des variables d'état du système,
- $u(t) = (\alpha_1 \quad \cdots \quad \alpha_N) \in \mathbb{R}^m$ représente le vecteur de commande considéré comme une entrée au système, $\alpha_k$ étant le rapport cyclique appliqué à l'interrupteur $S_k$ de la kième cellule de commutation, et 1- $\alpha_k$ le rapport cyclique appliqué à l'interrupteur $\overline{S_k}$ de la kième cellule de commutation.
- $f(X)$ et $g(X)$ sont les des fonctions non linéaires indéfiniment dérivables ;
- ($L_1$, $L_2$, ..., $L_N$) et $C_{out}$ sont les inductances de chaque cellule de commutation et le condensateur en sortie du convertisseur *Boost* respectivement;
- $i_1$, $i_2$, ..., $i_N$ et $V_{out}$ sont les courants dans chaque inductance et la tension en sortie du convertisseur *Boost* respectivement ;
- $P_{out}$ est la puissance de la charge dynamique raccordée au convertisseur *Boost* en sortie.

L'objectif du procédé selon l'invention est de contrôler le flux de l'énergie, depuis la source de tension en entrée vers la charge en sortie, tout en régulant la tension en sortie $V_{out}$ du convertisseur *Boost* à une valeur de consigne notée $V_{out}^{ref}$.

La première étape du procédé consiste à choisir le vecteur de sortie, noté y, de manière à permettre une linéarisation globale du système.

L'équation suivante (4) permet d'obtenir un vecteur de sortie du système globalement linéarisé avec des dynamiques internes qui sont nulles, pour le cas d'un convertisseur à *N* bras :

$$y = h(X,t) = \frac{1}{2}\sum_{k=1}^{N} L_k i_k^2 + \frac{1}{2}C_{out}V_{out}^2 \tag{4}$$

Une deuxième étape du procédé comprend une série de dérivations successives du vecteur de sortie y jusqu'à l'apparition du vecteur commande $u(t) = \alpha_{k=1,\dots,N}$ :

Tout d'abord, une dérivée de premier ordre pour l'équation (4) donne l'équation suivante :

$$\dot{y} = \left[V_{in}\sum_{k=1}^{N} i_k\right] - P_{out} \tag{5}$$

Cette équation représente les pertes générées par le convertisseur *Boost* ou son bilan énergétique.

Ensuite, une dérivée de second ordre pour l'équation (4) donne l'équation suivante :

$$\ddot{y} = V_{in}^2 \left( \sum_{k=1}^{N} \frac{1}{L_k} \right) - V_{in} V_{out} \left( \sum_{k=1}^{N} \frac{1-\alpha_k}{L_k} \right) - \frac{dP_{out}}{dt} \tag{6}$$

Ensuite on met en œuvre une étape de calcul du flux d'énergie $\dot{\Psi}_k$ traversant chaque cellule de commutation k, ce qui permet, avec l'équation (6), d'obtenir un système de $N$ équations à $N$ inconnues par lequel nous pouvons déterminer la commande $\alpha_k$ nécessaire pour chaque cellule $k$ du convertisseur *Boost* à N cellules.

$$\begin{cases} \dot{\Psi}_2 = \left( \frac{1}{L_1} - \frac{1}{L_2} \right) V_{in} - \left[ \frac{(1-\alpha_1)}{L_1} - \frac{(1-\alpha_2)}{L_2} \right] V_{out} \\ \dot{\Psi}_3 = \left( \frac{1}{L_1} - \frac{1}{L_3} \right) V_{in} - \left[ \frac{(1-\alpha_1)}{L_1} - \frac{(1-\alpha_3)}{L_3} \right] V_{out} \\ \qquad\qquad \vdots \\ \dot{\Psi}_N = \left( \frac{1}{L_1} - \frac{1}{L_N} \right) V_{in} - \left[ \frac{(1-\alpha_1)}{L_1} - \frac{(1-\alpha_N)}{L_N} \right] V_{out} \end{cases} \tag{7}$$

Avec $\dot{\Psi}_k = \frac{d(i_1 - i_k)}{dt}$ avec $k > 1$.

Partant de l'équation, (7) précédente, on détermine :

- l'équation de la commande de la première cellule du convertisseur *Boost* à N bras de la façon suivante :

$$(1 - \alpha_1) = \frac{V_{in}}{V_{out}} - \frac{L_1}{N V_{out}} \left[ \frac{\ddot{y}}{V_{in}} + \sum_{k=2}^{N} \dot{\Psi}_k + \frac{\dot{P}_{out}}{V_{in}} \right] \tag{8}$$

- Les équations des commandes des $N$ - 1 cellules du convertisseur *Boost* :

$$\begin{cases} (1 - \alpha_2) = \frac{V_{in}}{V_{out}} - \frac{L_2}{N V_{out}} \left[ \frac{\ddot{y}}{V_{in}} - (N-1)\dot{\Psi}_2 + \sum_{k=1}^{N-2} \sum_{\substack{m=N-(k-1) \\ m \neq 2}}^{N} \dot{\Psi}_m + \frac{\dot{P}_{out}}{V_{in}} \right] \\ (1 - \alpha_3) = \frac{V_{in}}{V_{out}} - \frac{L_3}{N V_{out}} \left[ \frac{\ddot{y}}{V_{in}} - (N-1)\dot{\Psi}_3 + \sum_{k=1}^{N-2} \sum_{\substack{m=N-(k-1) \\ m \neq 3}}^{N} \dot{\Psi}_m + \frac{\dot{P}_{out}}{V_{in}} \right] \\ \qquad\qquad\qquad \vdots \\ (1 - \alpha_N) = \frac{V_{in}}{V_{out}} - \frac{L_3}{N V_{out}} \left[ \frac{\ddot{y}}{V_{in}} - (N-1)\dot{\Psi}_{N-1} + \sum_{k=1}^{N-2} \sum_{\substack{m=N-(k-1) \\ m \neq N}}^{N} \dot{\Psi}_m + \frac{\dot{P}_{out}}{V_{in}} \right] \end{cases} \tag{9}$$

Afin d'avoir un suivi asymptotique stable de l'erreur, on pose :

$$\ddot{y} = k_1'(\dot{y}^{ref} - \dot{y}) + k_2'(y^{ref} - y) + k_3' \int_\tau (y^{ref} - y) d\tau \tag{10}$$

où $\{k_1', k_2', k_3'\}$ sont des gains calibrables du régulateur de l'équation (10) Et

$$\dot{\Psi}_k = k_1\left(\Psi_k^{\ ref} - \Psi_k\right) + k_2 \int_\tau \left(\Psi_k^{\ ref} - \Psi_k\right)d\tau \qquad (11)$$

où $\{k_1, k_2\}$ sont des gains calibrables du régulateur de l'équation (11) et $\Psi_k = i_1 - i_k$, et $\Psi_k^{ref}$ la consigne de flux de la kième cellule. Plus généralement les variables indexées « ref » se rapportent à des valeurs de consigne de la variable correspondante.

Ainsi, le calcul de ÿ à l'équation (6) qui représente une commande par retour d'état comprend, en référence à l'équation (10) :

- une action proportionnelle qui agit sur l'erreur $V_{in}\sum_{k=1}^{N}\left[i_k^{\ ref} - i_k\right]$ ;
- une action proportionnelle qui agit sur l'erreur entre y et $y^{ref}$ ;
- une action intégrale qui agit sur l'erreur entre $y$ et $y^{ref}$ ;

Le calcul de $y^{ref}$, le vecteur de sortie de consigne, et de sa dérivée $\dot{y}^{ref}$ sont obtenus par l'équation suivante:

$$y^{ref} = \frac{1}{2}\sum_{k=1}^{N} L_k\left(i_k^{\ ref}\right)^2 + \frac{1}{2}C_{out}\left(V_{out}^{\ ref}\right)^2 \qquad (12)$$

Et où :

$$\begin{cases} i_k^{\ ref} = \dfrac{P_{out}}{N \times \eta \times V_{in}} \\ V_{out}^{\ ref} \geq V_{in} \end{cases} \qquad (13)$$

avec $\eta$ représentant le rendement du système qui dépend du point de fonctionnement et N représente le numéro de la cellule.

Et :

$$\dot{y}^{ref} = \left[V_{in}\sum_{k=1}^{N} i_k^{\ ref}\right] - P_{out} \qquad (14)$$

En reprenant les équations (8) et (9), on remarque qu'en régime stabilisé, les $N$ rapports cycliques $\alpha_{k=1,\dots,N}$ convergent vers la valeur finale suivante :

$$\alpha_{k=1,\dots,N} = 1 - \frac{V_{in}}{V_{out}} \qquad (15)$$

Cette expression correspond à la fonction de transfert en boucle ouverte (autrement dit, le gain statique) du convertisseur *Boost.*

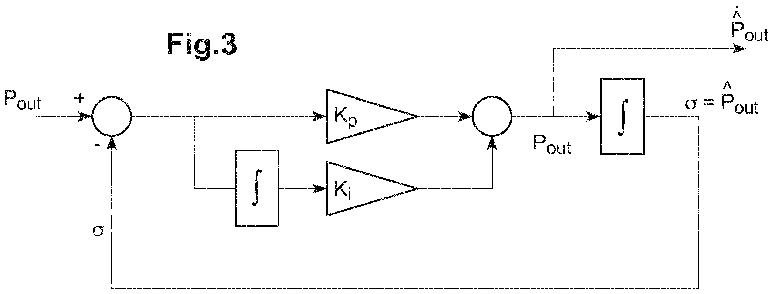

Pour calculer la dérivée de la puissance de sortie $\dot{P}_{out}$, en référence à la figure 3, on effectue le changement de variable suivant :

$$\begin{cases} \sigma = \hat{P}_{out} \\ \dot{\sigma} = \hat{\dot{P}}_{out} \end{cases} \qquad (16)$$

Où $\hat{P}_{out\_}$ est la puissance de sortie estiméereprésentée par la figure 3. On souhaite obtenir en régime stabilisé :

$$\begin{cases} \sigma \neq 0 \\ \dot{\sigma} = 0 \end{cases} \qquad (17)$$

Aussi, en référence à la figure 3, la variation de la puissance de sortie est estimée par l'équation suivante :

$$\dot{\sigma} = k_p(P_{out} - \sigma) + k_i \int_\tau (P_{out} - \sigma)d\tau \qquad (18)$$

avec $\{k_p, k_i\}$ qui sont des gains calibrables.

Ainsi la variation de la puissance de la charge $\dot{P}_{out}$ est obtenue à travers un observateur d'ordre réduit.

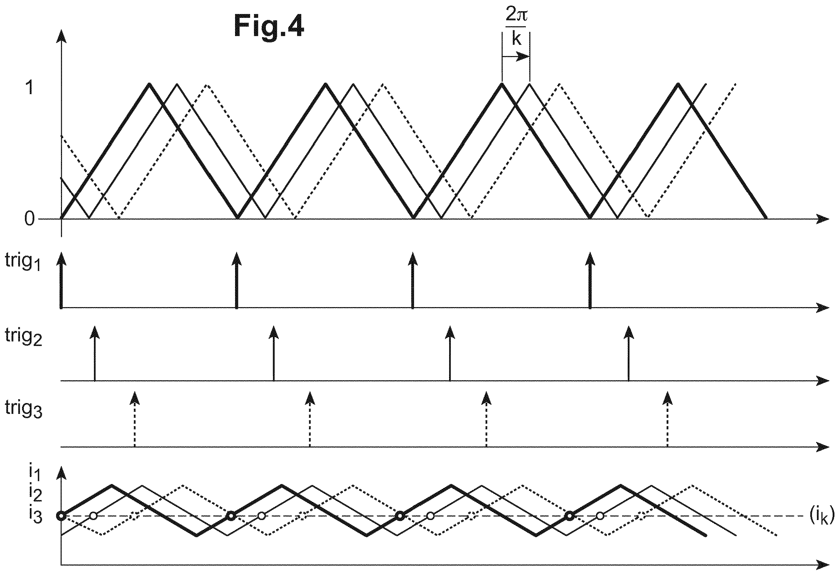

Ensuite le procédé met en œuvre une étape d'échantillonnage des courants afin de récupérer leur valeur moyenne et la génération du découpage, en référence à la figure 4.

Les signaux haute-fréquence dédiés au découpage de chaque cellule de commutation, et notés $PWM_{k=1,...,N}$, sont générés à travers une comparaison logique entre les signaux de commande notés $\alpha_{k=1,...,N}$ et un signal triangulaire symétrique haute-fréquence (nommé la porteuse) qui impose la fréquence de découpage du convertisseur de puissance. De plus, il existe une porteuse par cellule de commutation.

Chaque porteuse est déphasée de l'autre de *2qπ/N* avec *q* est un entier naturel multiple de deux et *N* est le nombre de cellules de commutation.

Ceci dit, pour la cellule de commutation numéro 1, on suit la logique suivante :

- Si $\alpha_1 \geq$ *porteuse*$_1$, *PWM*$_1$ = 1.
- Si non, *PWM*$_1$ = 0.

Pour la cellule de commutation numéro 2, on suit la logique suivante :

- Si $\alpha_2 \geq$ *porteuse*$_2$, *PWM*$_2$ = 1.
- Si non, *PWM*$_2$ = 0.

Avec *porteuse*$_2$ est déphasée de *porteuse*$_1$ de *2π/N*.

Pour la cellule de commutation numéro 3, on suit la logique suivante :

- Si $\alpha_3 \geq$ *porteuse*$_3$, *PWM*$_3$ = 1.
- Si non, *PWM*$_3$ = 0.

Avec *porteuse*$_3$ est déphasée de *porteuse*$_1$ de *4π/N*.

Pour la cellule de commutation numéro k, on suit la logique suivante :

- Si $\alpha_k \geq$ *porteuse*$_k$, *PWM*$_k$ = 1.
- Si non, *PWM*$_k$ = 0.

Avec *porteuse*$_k$ est déphasée de *porteuse*$_1$ de *2qπ/N.*

Ainsi, on peut capter la valeur moyenne de chaque courant notée $\langle i_k \rangle$, à travers un échantillonnage qui se fait à la valeur minimale (ou maximale) de chaque porteuse. le signal d'échantillonnage (noté *trig*$_k$) est en phase avec la porteuse qui lui est correspondante.

Cette approche, applicable que dans le cadre où une cible matérielle de type FPGA est utilisée, permet de nous libérer de l'approche de filtrage des courants qui induirait un retard dans la commande qu'il faudrait compenser.

Le signal d'échantillonnage du courant mesuré dans l'inductance se fait à la valeur minimale ou maximale de la porteuse afin de récupérer la composante moyenne du courant sans rajouter du retard qui provient du filtrage du signal réel dans le cas où un filtre passe-bas numérique est utilisé.

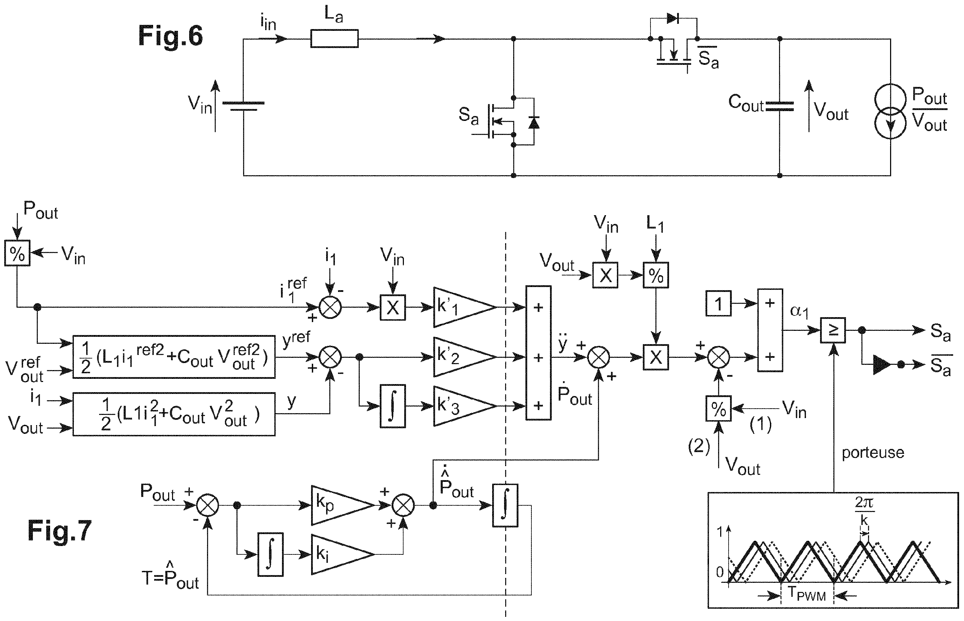

Dans un deuxième mode de réalisation de l'invention, pour un convertisseur *Boost* à une seule cellule de commutation, aussi appelé convertisseur Boost mono-étage, en référence à la figure 1 et aux figures 6 et 7, le procédé comprend les mêmes étapes principales de réalisation mais leurs modes de calcul peuvent être simplifiés.

Les équations du convertisseur *Boost* mono-étage sont les suivantes :

$$\begin{cases} C_{out} \dfrac{dV_{out}}{dt} = (1 - \alpha_1) \cdot i_1 - \dfrac{P_{out}}{V_{out}} \\[3mm] L_1 \dfrac{di_1}{dt} = V_{in} - (1 - \alpha_1) \cdot V_{out} \end{cases} \qquad (19)$$

L'équation (19) peut s'écrire sous la forme générique d'une équation non-linéaire affine suivante :

$$\frac{dX}{dt} = f(X, t) + g(X, t) \cdot u(t) \tag{20}$$

Ainsi, l'équation (20) devient :

$$\begin{pmatrix} \dfrac{di_1}{dt} \\ \dfrac{dV_{out}}{dt} \end{pmatrix} = \begin{pmatrix} \dfrac{V_{in} - V_{out}}{L_1} \\ \dfrac{1}{C_{out}} \cdot \left( i_1 - \dfrac{P_{out}}{V_{out}} \right) \end{pmatrix} + \begin{pmatrix} \dfrac{V_{out}}{L_1} \\ \dfrac{-i_1}{C_{out}} \end{pmatrix} \alpha_1 \tag{21}$$

avec

- $X \in \mathbb{R}^2 = (i_1 \quad V_{out})^t$ le vecteur des variables d'état du système,
- $u(t) = \alpha_1 \in \mathbb{R}^{\wedge}\mathbf{1}$ représente le vecteur de commande considéré comme une entrée au système, $\alpha_1$ étant le rapport cyclique appliqué à l'interrupteur $S_a$ de la cellule de commutation, et 1- $\alpha_1$ le rapport cyclique appliqué à l'interrupteur $\overline{S_a}$ de la cellule de commutation.
- $f(X)$ et $g(X)$ sont desfonctions non linéaires indéfiniment dérivables ;
- $L_1$ et $C_{out}$ sont l'inductance et le condensateur du boost respectivement;
- $i_1$ et $V_{out}$ sont le courant dans l'inductance et la tension en sortie du boost respectivement ;
- $P_{out}$ est la puissance de la charge dynamique raccordée au convertisseur *Boost* en sortie.

L'objectif du procédé selon ce mode de réalisation est alors de contrôler, à travers une seule boucle de régulation, le flux de l'énergie depuis la source de tension en entrée vers la charge en sortie, tout en régulant la tension en sortie $V_{out}$ du convertisseur boost à une valeur de consigne notée $V_{out}^{ref}$ .

La première étape du procédé consiste à choisir le vecteur de sortie de manière à permettre une linéarisation globale du système.

L'équation suivante (22), qui représente le vecteur de sortie qui permet de linéariser globalement le système d'équation (21),permet d'obtenir un vecteur de sortie du système globalement linéarisé, pour le cas d'un convertisseur *Boost* mono-étage:

$$y = h(\boldsymbol{X}, t) = \frac{1}{2} L_1 i_1^2 + \frac{1}{2} C_{out} V_{out}^2 \tag{22}$$

Une deuxième étape du procédé comprend un changement de repère, à travers une série de dérivées successives jusqu'à l'apparition du vecteur commande u(t) = $\alpha_{k=1,...,N}$ :

Tout d'abord, une dérivée de premier ordre pour l'équation (22) donne l'équation suivante :

$$\dot{y} = V_{in} i_1 - P_{out} \tag{23}$$

Cette équation représente les pertes générées par le convertisseur Boost.

Ensuite, une dérivée de second ordre pour l'équation (22) donne l'équation suivante :

$$\ddot{y} = \frac{V_{in}^2}{L_1} - V_{in} V_{out} \left( \frac{1 - \alpha_1}{L_1} \right) - \frac{dP_{out}}{dt} \tag{24}$$

Partant de là, on en déduit l'équation du rapport cyclique $\alpha_1$ tel que :

$$\alpha_1 = 1 - \frac{V_{in}}{V_{out}} + \frac{L_1}{V_{in}V_{out}}[\ddot{y} + \dot{P}_{out}] \tag{25}$$

Avec $\dot{P}_{out} = \frac{dP_{out}}{dt}$.

Or, en régime stabilisé (à puissance constante), le rapport cyclique $\alpha_1$ converge vers la valeur finale suivante :

$$\alpha_1 = 1 - \frac{V_{in}}{V_{out}} \tag{26}$$

Ainsi, le rapport cyclique calculé en (25) de manière dynamique, converge de manière asymptotique et stable vers l'équation (26) en régime stabilisé

Cette expression correspond à la fonction de transfert en boucle ouverte (autrement dit, le gain statique) du convertisseur *Boost 2.*

Afin d'avoir un suivi exponentiel asymptotique, on pose :

- Pour le calcul de la dérivée seconde du vecteur de commande $\ddot{y}$ :

$$(\ddot{y} - \ddot{y}^{ref}) + k_1'(\dot{y} - \dot{y}^{ref}) + k_2'(y - y^{ref}) + k_3' \int_\tau (y - y^{ref})d\tau = 0 \tag{27}$$

avec $\ddot{y}^{ref} = \dot{y}^{ref} = 0$ et y obtenu par l'équation (23) présentée précédemment. Ainsi, on détermine la forme générique du premier régulateur tel que :

$$\ddot{y} = k_1'(\dot{y}^{ref} - \dot{y}) + k_2'(y^{ref} - y) + k_3' \int_\tau (y^{ref} - y)d\tau \tag{28}$$

avec $\{k_1', k_2', k_3'\}$ sont des gains calibrables du régulateur.

Le calcul de $\ddot{y}$, qui correspond à une commande par retour d'état, en référence à l'équation (28) comprend donc :

- une action proportionnelle qui agit sur l'erreur $V_{in}(i_1^{ref} - i_1)$ ;
- une action proportionnelle qui agit sur l'erreur entre y et $y^{ref}$ ;
- une action intégrale qui agit sur l'erreur entre y et $y^{ref}$ ;

D'autre part, le calcul de $y^{ref}$ et de $\dot{y}^{ref}$ se fait de la façon suivante :

$$y^{ref} = \frac{1}{2}L_1(i_1^{ref})^2 + \frac{1}{2}C_{out}(V_{out}^{ref})^2 \tag{29}$$

avec

$$\begin{cases} i_1^{ref} = \dfrac{P_{out}}{\eta \times V_{in}} \\ V_{out}^{ref} \geq V_{in} \end{cases} \tag{30}$$

avec η représente le rendement du système qui dépend du point de fonctionnement.

De plus,

$$\dot{y}^{ref} = V_{in}i_1^{ref} - P_{out} \tag{31}$$

- Et pour l'estimation de la variation de la dérivée de la puissance en sortie $\dot{P}_{out}$ :

On effectue le changement de variable suivant :

$$\begin{cases} \sigma = \hat{P}_{out} \\ \dot{\sigma} = \dot{\hat{P}}_{out} \end{cases} \qquad (32)$$

Et on souhaite avoir en régime stabilisé :

$$\begin{cases} \sigma \neq 0 \\ \dot{\sigma} = 0 \end{cases} \qquad (33)$$

Partant de là, la variation de la puissance de sortie est estimée de la façon suivante :

$$\dot{\sigma} = k_p(P_{out} - \sigma) + k_i \int_\tau (P_{out} - \sigma)d\tau \qquad (34)$$

avec $k_p$ et $k_i$ sont des gains calibrables.

**Revendications**

1. Procédé de commande d'un convertisseur *Boost* (2) à N cellules de commutations en modulation de largeur d'impulsion synchrone, dans lequel N est un entier naturel non nul, le convertisseur recevant en entrée une tension électrique ($V_{in}$) continue d'une source de tension et fournissant en sortie une tension de sortie ($V_{out}$) supérieure ou égale à la tension d'entrée ($V_{in}$), le procédé comprenant :

   - Une étape de mesure des tensions d'entrée ($V_{in}$) et de sortie ($V_{out}$) dudit convertisseur *Boost* (2) ;
   - Une étape de détermination d'un vecteur de sortie (y) adapté pour linéariser globalement le système d'équations du convertisseur *Boost* (2) ;
   - une étape de calcul de la variation de puissance de la charge électrique en sortie du convertisseur ($\dot{P}_{out}$) ;
   - Une étape de détermination des N rapports cycliques ($\alpha_k$) du convertisseur en fonction de la dérivée seconde ($\ddot{y}$) du vecteur de sortie (y), de la dérivée de la puissance de la charge électrique ($\dot{P}_{out}$) et du rapport entre la tension d'entrée ($V_{in}$) et la tension de sortie ($V_{out}$) mesurées ; et
   - Une étape de commande de chaque cellule de commutation (k) du convertisseur (2), en fonction du rapport cyclique déterminé ($\alpha_k$).

2. Procédé selon la revendication 1, lorsque le convertisseur comprend N>1 cellules de commutations (k), **caractérisé en ce que** l'étape de détermination des N rapports cycliques comprend le calcul du flux d'énergie ($\dot{\Psi}_k$) traversant chaque cellule de commutation (k).

3. Procédé selon la revendication 2, dans lequel le convertisseur Boost (2) comprend pour chaque cellule de commutation une inductance (Lk), **caractérisé en ce que** l'étape de détermination des N rapports cycliques comprend ;

   - Le calcul du rapport cyclique ($\alpha_1$) pour la première cellule de commutation (k=1) en fonction de la somme des flux d'énergie calculés ($\dot{\Psi}_k$) pour les cellules de commutation à partir de la deuxième par application de la formule suivante :

$$(1 - \alpha_1) = \frac{V_{in}}{V_{out}} - \frac{L_1}{NV_{out}}\left[\frac{\ddot{y}}{V_{in}} + \sum_{k=2}^{N} \dot{\Psi}_k + \frac{\dot{P}_{out}}{V_{in}}\right]$$

dans laquelle:

$\alpha_1$ étant le rapport cyclique pour la première cellule de commutation,

Vin étant la tension d'entrée du convertisseur Boost,

Vout étant la tension de sortie du convertisseur Boost,

L1 étant l'inductance de la première cellule de commutation,

N étant le nombre de cellules de commutation,

$\ddot{y}$ étant la dérivée seconde du vecteur de sortie,

$\dot{\Psi}_k$ étant flux d'énergie traversant la k-ième cellule de commutation,

$\dot{P}_{out}$ étant la variation de puissance de la charge électrique en sortie du convertisseur.

4. Procédé selon la revendication 2 ou 3, dans lequel le convertisseur Boost (2) comprend pour chaque cellule de commutation une inductance (Lk), **caractérisé en ce que** l'étape de détermination des N rapports cycliques comprend le calcul du rapport cyclique de chaque cellule de commutation autre que la première (k>1), en fonction des flux d'énergie calculés ($\dot{\Psi}_k$) par application du système d'équations suivant :

$$\begin{cases} (1 - \alpha_2) = \dfrac{V_{in}}{V_{out}} - \dfrac{L_2}{NV_{out}} \left[ \dfrac{\ddot{y}}{V_{in}} - (N-1)\dot{\Psi}_2 + \sum_{k=1}^{N-2} \sum_{\substack{m=N-(k-1) \\ m \neq 2}}^{N} \dot{\Psi}_m + \dfrac{\dot{P}_{out}}{V_{in}} \right] \\[4ex] (1 - \alpha_3) = \dfrac{V_{in}}{V_{out}} - \dfrac{L_3}{NV_{out}} \left[ \dfrac{\ddot{y}}{V_{in}} - (N-1)\dot{\Psi}_3 + \sum_{k=1}^{N-2} \sum_{\substack{m=N-(k-1) \\ m \neq 3}}^{N} \dot{\Psi}_m + \dfrac{\dot{P}_{out}}{V_{in}} \right] \\[2ex] \vdots \\[1ex] (1 - \alpha_N) = \dfrac{V_{in}}{V_{out}} - \dfrac{L_3}{NV_{out}} \left[ \dfrac{\ddot{y}}{V_{in}} - (N-1)\dot{\Psi}_{N-1} + \sum_{k=1}^{N-2} \sum_{\substack{m=N-(k-1) \\ m \neq N}}^{N} \dot{\Psi}_m + \dfrac{\dot{P}_{out}}{V_{in}} \right] \end{cases}$$

dans laquelle:

$\alpha_k$ étant le rapport cyclique pour la k-ième cellule de commutation,

Vin étant la tension d'entrée du convertisseur Boost,

Vout étant la tension de sortie du convertisseur Boost,

Lk étant l'inductance de la k-ième cellule de commutation,

N étant le nombre de cellules de commutation,

$\ddot{y}$ étant la dérivée seconde du vecteur de sortie,

$\dot{\Psi}_k$ étant flux d'énergie traversant la k-ième cellule de commutation,

$\dot{P}_{out}$ étant la variation de puissance de la charge électrique en sortie du convertisseur.

5. Procédé selon la revendication 1, lorsque le convertisseur comprend une unique cellule de commutation comprenant une inductance (L1), **caractérisé en ce que** l'étape de détermination du rapport cyclique comprend l'application de l'équation suivante :

$$\alpha_1 = 1 - \frac{V_{in}}{V_{out}} + \frac{L_1}{V_{in} V_{out}} \left[ \ddot{y} + \dot{P}_{out} \right]$$

dans laquelle:

$\alpha_1$ étant le rapport cyclique pour ladite unique cellule de commutation,

Vin étant la tension d'entrée du convertisseur Boost,

Vout étant la tension de sortie du convertisseur Boost,

L1 étant l'inductance de ladite unique cellule de commutation,

$\ddot{y}$ étant la dérivée seconde du vecteur de sortie,

$\dot{P}_{out}$ étant la variation de puissance de la charge électrique en sortie du convertisseur.

**6.** Procédé selon l'une quelconque des revendications 1 à 5, **caractérisé en ce que** l'étape de commande de chaque cellule de commutation comprend la génération d'un signal de commande, $PWM_k$, pour chaque cellule de commutation, fonction d'une comparaison logique entre les rapports cycliques déterminés, $\alpha_{k=1,...,N}$, et une porteuse, *porteuse_k*, triangulaire symétrique haute-fréquence, imposant une fréquence de découpage du convertisseur (2).

**7.** Procédé selon la revendication 6, **caractérisé en ce que** la comparaison comprend :

pour la première cellule de commutation (k=1) :

- Si $\alpha_1 \geq porteuse_1$, $PWM_1 = 1$ ;
- sinon, $PWM_1 = 0$ ;

Pour les autres cellules de commutation (k>1) :

- Si $\alpha_k \geq porteuse_k$, $PWM_k = 1$ ;
- Sinon, $PWM_k = 0$ ;

avec *porteuse_k* déphasée de $porteuse_1$ de $2q\pi/N$, où q est un entier naturel multiple de deux.

**8.** Procédé selon l'une quelconque des revendications 1 à 7, dans lequel le convertisseur *Boost* (2) comprend pour chaque cellule de commutation une inductance ($L_k$), **caractérisé en ce qu'**on calcule le vecteur de sortie (y) en outre en fonction des courants mesurés ($i_k$) pour chaque inductance ($L_k$).

**9.** Procédé selon la revendication 8, lorsqu'elle dépend de la 6 ou la 7, **caractérisé en ce que** les valeurs moyennes des courants ($i_k$) mesurés pour chaque inductance ($L_k$) sont obtenues en échantillonnant à la valeur minimale ou maximale chacune des N porteuses utilisées pour la génération du découpage des interrupteurs de puissance

**10.** Ensemble électrique (10) comprenant une source électrique de courant continu (1), un convertisseur Boost (2) à N cellules de commutation, un convertisseur de tension continu-alternatif (3), une machine électrique (4), et un dispositif de commande dudit convertisseur Boost adapté pour mettre en œuvre un procédé selon l'une quelconque des revendications 1 à 9.

**Patentansprüche**

**1.** Verfahren zur Steuerung eines Aufwärtswandlers (2) mit N Schaltzellen in synchroner Impulsbreitenmodulation, wobei N eine natürliche Zahl ungleich Null ist, wobei der Wandler am Eingang eine elektrische Gleichspannung ($V_{in}$) von einer Spannungsquelle empfängt und am Ausgang eine Ausgangsspannung ($V_{out}$) höher als die oder gleich der Eingangsspannung ($V_{in}$) liefert, wobei das Verfahren enthält:

- einen Schritt der Messung der Eingangs- ($V_{in}$) und Ausgangsspannungen ($V_{out}$) des Aufwärtswandlers (2);
- einen Schritt der Bestimmung eines Ausgangsvektors (y), der geeignet ist, das System von Gleichungen des Aufwärtswandlers (2) global zu linearisieren;
- einen Schritt der Berechnung der Leistungsänderung der elektrischen Ladung am Ausgang des Wandlers ($\dot{P}_{out}$);
- einen Schritt der Bestimmung der N Tastverhältnisse ($\alpha_k$) des Wandlers abhängig von der zweiten Ableitung ($\ddot{y}$) des Ausgangsvektors (y), der Ableitung der Leistung der elektrischen Ladung ($\dot{P}_{out}$) und des Verhältnisses zwischen den gemessenen Eingangs-($V_{in}$) und Ausgangsspannungen ($V_{out}$) ; und
- einen Schritt der Steuerung jeder Schaltzelle (k) des Wandlers (2) abhängig vom bestimmten Tastverhältnis ($\alpha_k$).

**2.** Verfahren nach Anspruch 1, wenn der Wandler N>1 Schaltzellen (k) enthält, **dadurch gekennzeichnet, dass** der Schritt der Bestimmung der N Tastverhältnisse die Berechnung des jede Schaltzelle (k) durchquerenden Energieflusses ($\dot{\Psi}_k$) enthält.

**3.** Verfahren nach Anspruch 2, wobei der Aufwärtswandler (2) für jede Schaltzelle eine Induktivität ($L_k$) enthält, **dadurch gekennzeichnet, dass** der Schritt der Bestimmung der N Tastverhältnisse enthält:

- die Berechnung des Tastverhältnisses ($\alpha_1$) für die erste Schaltzelle (k=1) abhängig von der Summe der berechneten Energieflüsse ($\dot{\Psi}_k$) für die Schaltzellen ab der zweiten durch Anwendung der folgenden Formel:

$$(1 - a_1) = \frac{V_{in}}{V_{out}} - \frac{L_1}{NV_{out}}\left[\frac{\ddot{y}}{V_{in}} + \sum_{k=2}^{N}\dot{\Psi}_k + \frac{\dot{P}_{out}}{V_{in}}\right]$$

wobei:

$\alpha_1$ das Tastverhältnis für die erste Schaltzelle ist,
$V_{in}$ die Eingangsspannung des Aufwärtswandlers ist,
$V_{out}$ die Ausgangsspannung des Aufwärtswandlers ist,
$L_1$ die Induktivität der ersten Schaltzelle ist,
N die Anzahl von Schaltzellen ist,
$\ddot{y}$ die zweite Ableitung des Ausgangsvektors ist,
$\dot{\Psi}_k$ der die k-te Schaltzelle durchquerende Energiefluss ist,
$\dot{P}_{out}$ die Leistungsänderung der elektrischen Ladung am Ausgang des Wandlers ist.

4.  Verfahren nach Anspruch 2 oder 3, wobei der Aufwärtswandler (2) für jede Schaltzelle eine Induktivität ($L_k$) enthält, **dadurch gekennzeichnet, dass** der Schritt der Bestimmung der N Tastverhältnisse die Berechnung des Tastverhältnisses jeder Schaltzelle anders als die erste (k>1) abhängig von den berechneten Energieflüssen ($\dot{\Psi}_k$) durch Anwendung des folgenden Systems von Gleichungen enthält:

$$\begin{cases} (1 - a_2) = \dfrac{V_{in}}{V_{out}} - \dfrac{L_2}{NV_{out}}\left[\dfrac{\ddot{y}}{V_{in}} - (N-1)\dot{\Psi}_2 + \sum_{k=1}^{N-2}\sum_{\substack{m=N-(k-1)\\m\neq 2}}^{N}\dot{\Psi}_m + \dfrac{\dot{P}_{out}}{V_{in}}\right] \\[2em] (1 - a_3) = \dfrac{V_{in}}{V_{out}} - \dfrac{L_3}{NV_{out}}\left[\dfrac{\ddot{y}}{V_{in}} - (N-1)\dot{\Psi}_3 + \sum_{k=1}^{N-2}\sum_{\substack{m=N-(k-1)\\m\neq 3}}^{N}\dot{\Psi}_m + \dfrac{\dot{P}_{out}}{V_{in}}\right] \\[1em] \vdots \\[1em] (1 - a_N) = \dfrac{V_{in}}{V_{out}} - \dfrac{L_3}{NV_{out}}\left[\dfrac{\ddot{y}}{V_{in}} - (N-1)\dot{\Psi}_{N-1} + \sum_{k=1}^{N-2}\sum_{\substack{m=N-(k-1)\\m\neq N}}^{N}\dot{\Psi}_m + \dfrac{\dot{P}_{out}}{V_{in}}\right] \end{cases}$$

wobei:

$\alpha_k$ das Tastverhältnis für die k-te Schaltzelle ist,
$V_{in}$ die Eingangsspannung des Aufwärtswandlers ist,
$V_{out}$ die Ausgangsspannung des Aufwärtswandlers ist,
$L_k$ die Induktivität der k-ten Schaltzelle ist,
N die Anzahl von Schaltzellen ist,
$\ddot{y}$ die zweite Ableitung des Ausgangsvektors ist,
$\dot{\Psi}_k$ der die k-te Schaltzelle durchquerende Energiefluss ist,
$\dot{P}_{out}$ die Leistungsänderung der elektrischen Ladung am Ausgang des Wandlers ist.

5.  Verfahren nach Anspruch 1, wenn der Wandler eine einzige Schaltzelle enthält, die eine Induktivität ($L_1$) enthält, **dadurch gekennzeichnet, dass** der Schritt der Bestimmung des Tastverhältnisses die Anwendung der folgenden Gleichung enthält:

$$a_1 = 1 - \frac{V_{in}}{V_{out}} + \frac{L_1}{V_{in}V_{out}}\left[\ddot{y} + \dot{P}_{out}\right]$$

wobei:

$\alpha_1$ das Tastverhältnis für die einzige Schaltzelle ist,
$V_{in}$ die Eingangsspannung des Aufwärtswandlers ist,
$V_{out}$ die Ausgangsspannung des Aufwärtswandlers ist,
$L_1$ die Induktivität der einzigen Schaltzelle ist,
$\ddot{y}$ die zweite Ableitung des Ausgangsvektors ist,
$\dot{P}_{out}$ die Leistungsänderung der elektrischen Ladung am Ausgang des Wandlers ist.

6. Verfahren nach einem der Ansprüche 1 bis 5, **dadurch gekennzeichnet, dass** der Steuerschritt jeder Schaltzelle die Erzeugung eines Steuersignals, $PWM_k$, für jede Schaltzelle abhängig von einem logischen Vergleich zwischen den bestimmten Tastverhältnissen, $\alpha_{k=1}, ... N$, und einem symmetrischen dreieckigen Hochfrequenzträger, $Träger_k$, enthält, das eine Taktfrequenz des Wandlers (2) vorgibt.

7. Verfahren nach Anspruch 6, **dadurch gekennzeichnet, dass** der Vergleich enthält:

für die erste Schaltzelle (k=1):

• wenn $\alpha_1 \geq Träger_1$, $PWM_1 = 1$;
• sonst, $PWM_1 = 0$;

für die anderen Schaltzellen (k>1):

• wenn $\alpha_k \geq Träger_k$, $PWM_k = 1$;
• sonst, $PWM_k = 0$;

mit $Träger_k$ um $2q\pi/N$ phasenverschoben zu $Träger_1$, wobei q eine natürliche Zahl ein Vielfaches von zwei ist.

8. Verfahren nach einem der Ansprüche 1 bis 7, wobei der Aufwärtswandler (2) für jede Schaltzelle eine Induktivität $(L_k)$ enthält, **dadurch gekennzeichnet, dass** der Ausgangsvektor (y) außerdem abhängig von den für jede Induktivität $(L_k)$ gemessenen Strömen $(i_k)$ berechnet wird.

9. Verfahren nach Anspruch 8, wenn er von Anspruch 6 oder Anspruch 7 abhängt, **dadurch gekennzeichnet, dass** die Mittelwerte der für jede Induktivität $(L_k)$ gemessenen Ströme $(i_k)$ durch Abtasten jedes der N Träger auf dem jedes der N Träger Minimal- oder Maximalwert erhalten werden, die für die Erzeugung der Taktung der Leistungsschalter verwendet werden.

10. Elektrische Einheit (10), die eine elektrische Gleichstromquelle (1), einen Aufwärtswandler (2) mit N Schaltzellen, einen Gleichspannungs-Wechselspannungswandler (3), eine elektrische Maschine (4) und eine Steuervorrichtung des Aufwärtswandlers enthält, die geeignet ist, ein Verfahren nach einem der Ansprüche 1 bis 9 durchzuführen.

**Claims**

1. Method for controlling a boost converter (2) with N switching cells in synchronous pulse-width modulation mode, wherein N is a non-zero natural integer, the converter receiving at its input a DC voltage $(V_{in})$ from a voltage source and delivering at its output an output voltage $(V_{out})$ which is greater than or equal to the input voltage $(V_{in})$, the method comprising:

- a step of measuring the input voltage $(V_{in})$ and output voltage $(V_{out})$ of said boost converter (2);
- a step of determining an output vector (y) designed for globally linearizing the system of equations of the boost converter (2);
- a step of calculating the variation in power of the electrical load at the output of the converter $(\dot{P}_{out})$ ;
- a step of determining the N duty cycles $(\alpha_k)$ of the converter depending on the second derivative $(\ddot{y})$ of the

output vector (y), the derivative of the power of the electrical load ($\dot{P}_{out}$) and the ratio between the input voltage ($V_{in}$) and the output voltage ($V_{out}$) which are measured; and
- a step of controlling each switching cell (k) of the converter (2), depending on the duty cycle ($\alpha_k$) which is determined.

2. Method according to Claim 1, when the converter comprises N>1 switching cells (k), **characterized in that** the step of determining the N duty cycles comprises calculating the energy flux ($\dot{\Psi}_k$) flowing through each switching cell (k).

3. Method according to Claim 2, wherein the boost converter (2) comprises an inductor ($L_k$) for each switching cell, **characterized in that** the step of determining the N duty cycles comprises:

• calculating the duty cycle ($\alpha_1$) for the first switching cell (k=1) depending on the sum of the energy fluxes ($\dot{\Psi}_k$) which are calculated for the switching cells on the basis of the second by applying the following formula:

$$(1 - \alpha_1) = \frac{V_{in}}{V_{out}} - \frac{L_1}{N V_{out}}\left[ \frac{\ddot{y}}{V_{in}} + \sum_{k=2}^{N} \dot{\Psi}_k + \frac{\dot{P}_{out}}{V_{in}} \right]$$

wherein:

$\alpha_1$ is the duty cycle for the first switching cell,
$V_{in}$ is the input voltage of the boost converter,
$V_{out}$ is the output voltage of the boost converter,
$L_1$ is the inductor of the first switching cell,
N is the number of switching cells,
$\ddot{y}$ is the second derivative of the output vector,
$\dot{\Psi}_k$ is the energy flux flowing through the kth switching cell,
$\dot{P}_{out}$ is the variation in power of the electrical load at the output of the converter.

4. Method according to Claim 2 or 3, wherein the boost converter (2) comprises an inductor ($L_k$) for each switching cell **characterized in that** the step of determining the N duty cycles comprises calculating the duty cycle of each switching cell other than the first (k>1), depending on the energy fluxes ($\dot{\Psi}_k$) which are calculated by applying the following system of equations:

$$\begin{cases} (1 - \alpha_2) = \dfrac{V_{in}}{V_{out}} - \dfrac{L_2}{N V_{out}}\left[ \dfrac{\ddot{y}}{V_{in}} - (N-1)\dot{\Psi}_2 + \sum_{k=1}^{N-2}\sum_{\substack{m=N-(k-1)\\ m\neq 2}}^{N} \dot{\Psi}_m + \dfrac{\dot{P}_{out}}{V_{in}} \right] \\[2em] (1 - \alpha_3) = \dfrac{V_{in}}{V_{out}} - \dfrac{L_3}{N V_{out}}\left[ \dfrac{\ddot{y}}{V_{in}} - (N-1)\dot{\Psi}_3 + \sum_{k=1}^{N-2}\sum_{\substack{m=N-(k-1)\\ m\neq 3}}^{N} \dot{\Psi}_m + \dfrac{\dot{P}_{out}}{V_{in}} \right] \\[1em] \qquad\qquad\qquad\qquad\qquad \vdots \\[1em] (1 - \alpha_N) = \dfrac{V_{in}}{V_{out}} - \dfrac{L_3}{N V_{out}}\left[ \dfrac{\ddot{y}}{V_{in}} - (N-1)\dot{\Psi}_{N-1} + \sum_{k=1}^{N-2}\sum_{\substack{m=N-(k-1)\\ m\neq N}}^{N} \dot{\Psi}_m + \dfrac{\dot{P}_{out}}{V_{in}} \right] \end{cases}$$

wherein:

$\alpha_k$ is the duty cycle for the kth switching cell,
$V_{in}$ is the input voltage of the boost converter,
$V_{out}$ is the output voltage of the boost converter,
$L_k$ is the inductor of the kth switching cell,

N is the number of switching cells,

$\ddot{y}$ is the second derivative of the output vector,

$\Psi_k$ is the energy flux flowing through the kth switching cell,

$\dot{P}_{out}$ is the variation in power of the electrical load at the output of the converter.

**5.** Method according to Claim 1, when the converter comprises a single switching cell comprising an inductor ($L_1$), **characterized in that** the step of determining the duty cycle comprises applying the following equation:

$$a_1 = 1 - \frac{V_{in}}{V_{out}} + \frac{L_1}{V_{in} V_{out}} \left[ \ddot{y} + \dot{P}_{out} \right]$$

wherein:

$\alpha_1$ is the duty cycle for said single switching cell,

$V_{in}$ is the input voltage of the boost converter,

$V_{out}$ is the output voltage of the boost converter,

$L_1$ is the inductor of said single switching cell,

$\ddot{y}$ is the second derivative of the output vector,

$\dot{P}_{out}$ is the variation in power of the electrical load at the output of the converter.

**6.** Method according to any one of Claims 1 to 5, **characterized in that** the step of controlling each switching cell comprises generating a control signal, $PWM_k$, for each switching cell, which depends on a logical comparison between the duty cycles, $\alpha_{k=1,...,N}$, which are determined and a high-frequency symmetrical triangular carrier, carrier$_k$, dictating a chopping frequency of the converter (2).

**7.** Method according to Claim 6, **characterized in that** the comparison comprises:

for the first switching cell (k=1):

- if $\alpha_1 \geq$ carrier$_1$, $PWM_1 = 1$;
- otherwise, $PWM_1 = 0$;

for the other switching cells (k>1):

- if $\alpha_k \geq$ carrier$_k$, $PWM_k = 1$;
- otherwise, $PWM_k = 0$;

with carrier$_k$ phase-shifted from carrier$_1$ by 2qn/N,
where q is a natural integer which is a multiple of two.

**8.** Method according to any one of Claims 1 to 7, wherein the boost converter (2) comprises an inductor ($L_k$) for each switching cell, **characterized in that** the output vector (y) is calculated depending furthermore on the currents ($i_k$) which are measured for each inductor ($L_k$).

**9.** Method according to Claim 8, when it is dependent on Claim 6 or 7, **characterized in that** the average values of the currents ($i_k$) which are measured for each inductor ($L_k$) are obtained by sampling, at the minimum or maximum value, each of the N carriers which are used for generating the chopping of the power switches.

**10.** Electrical assembly (10) comprising an electrical DC current source (1), a boost converter (2) with N switching cells, a DC-AC voltage converter (3), an electric machine (4), and a device for controlling said boost converter designed for implementing a method according to any one of Claims 1 to 9.

Fig.1

**Fig.2**

Fig.3

**Fig.4**

EP 3 857 692 B1

Fig.5

EP 3 857 692 B1

**Fig.6**

**Fig.7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20170257038 A1

**Littérature non-brevet citée dans la description**

- **M. ZANDI ; J. MARTIN ; S. PIERFEDERICI ; M. PHATTANASAK ; B. NAHID-MOBARAKEH.** Control of a Two-Phase Interleaved Boost Converter with Input LC Filter for Fuel Cell Vehicle Applications. *2017 IEEE Vehicle Power and Propulsion Conférence (VP-PC),* 2017, 1-5